# EUROPÄISCHE PATENTANMELDUNG

(11) **EP 3 537 039 A1**
(43) Veröffentlichungstag der Anmeldung: **11.09.2019**
(21) Anmeldenummer: 19161048.4
(22) Anmeldetag: 06.03.2019
(51) Int. Cl.: F21V 15/01, F21S 4/24, F21V 23/00, F21V 29/507, F21Y 103/10, F21Y 103/20, F21Y 107/70, F21Y 115/10, H01L 25/075, H01L 33/52, H01L 33/58, H01L 33/62, H01L 33/64, H05B 33/04, H05B 33/08

(54) **VERKAPSELUNGSSCHLAUCH FÜR EIN LINEARES LEUCHTDIODENMODUL UND LINEARES LEUCHTDIODENMODUL DAMIT**

(30) Priorität: 09.03.2018 DE 102018105487
(71) Anmelder: Bilton International GmbH, 5760 Saalfelden (AT)
(72) Erfinder: KNOFLACH, Norbert, 5722 Niedernsill (AT); MICHAL, Roland, 1230 Wien (AT); OBERLECHNER, Christian, 5760 Saalfelden (AT)
(74) Vertreter: Epping - Hermann - Fischer

(57) **Zusammenfassung**

Es ist ein Verkapselungsschlauch (10) für ein mindestens ein LED-Lichtband (20) aufweisendes lineares Leuchtdiodenmodul (1), mit einem entlang dessen Längsrichtung allseitig geschlossenen vorgefertigten Profil angegeben. Das Profil ist mit einem in Längsrichtung vollständig durch den Verkapselungsschlauch (10) verlaufenden LED-Kanal (13) versehen. Dieser ist dazu vorgesehen, das LED-Lichtband (20) einzuziehen, wobei der LED-Kanal (13) einerseits von einem lichtreflektierenden Trägerelement (11) und andererseits von einem lichtdurchlässigen Fensterelement (12) begrenzt ist. Das Trägerelement (11) weist mindestens einen entlang des LED-Kanals (13) verlaufenden ETM-Kanal (14) auf, der dazu vorgesehen ist, in diesen mindestens ein elektrisch, thermisch und/oder mechanisch wirksames Element einzuziehen. Des Weiteren ist ein lineares Leuchtdiodenmodul (1) angegeben.

## Beschreibung

Die vorliegende Erfindung betrifft einen insbesondere flexiblen Verkapselungsschlauch für ein insbesondere flexibles lineares Leuchtdiodenmodul, bei dem eine Mehrzahl von
- LED-Bauelementen - beispielsweise mit einer leadframebasierten Kunststoffumhüllung versehene LED-Chips wie beispielsweise PLCC2 SMD LEDs, PLCC4 SMD LEDs oder PLCC6 SMD LEDs) - beispielsweise in Oberflächen(SMD)-Montagetechnologie oder
- eine Mehrzahl von LED-Chips in Chip-on-board (COB)-Technologie
auf einer langgestreckten flexiblen Leiterplatte (auch Flex-PCB genannt) montiert und elektrisch verschaltet ist. Die LED-Bauelemente bzw. LED-Chips sind dabei vorzugsweise linear hintereinander auf dem Flex-PCB montiert.

Die lichtemittierenden Halbleiterkörper der LED-Chips können dabei auf anorganischen oder organischen
elektrolumineszierenden Materialien basieren.

LED-Bauelement und LED-Chip werden im Folgenden einheitlich mit "LED" bezeichnet. Das Flex-PCB mit den LEDs wird im Folgenden mit "LED-Lichtband" bezeichnet.

Ein solches LED-Lichtband muss, um es vor mechanischer Beschädigung sowie vor Staub, Wasser und anderen Umwelteinflüssen zu schützen, mit einer Verkapselung versehen sein.

Vorliegend ist als Verkapselung ein entlang der Längsrichtung des linearen Leuchtdiodenmoduls allseitig geschlossenes vorgefertigtes Profil mit einem in Längsrichtung durchgängigen Hohlraum (mit anderen Worten ein vorgefertigter Verkapselungsschlauch - im Folgenden "Verkapselungsschlauch" bezeichnet) vorgeschlagen, in den das LED-Lichtband eingeschoben und montiert ist. Der Verkapselungsschlauch umfasst ein über seine gesamte Länge verlaufendes lichtreflektierendes und/oder lichtlenkendes Trägerelement und ein über seine gesamte Länge verlaufendes lichtdurchlässiges Fensterelement.

Die begrenzenden Seitenflächen des Hohlraums sind zu einem ersten Teil über die gesamte Länge des Verkapselungsschlauches von dem lichtreflektierenden und/oder lichtlenkenden Trägerelement und zu einem zweiten Teil über die gesamte Länge des Verkapselungsschlauches von dem lichtdurchlässigen Fensterelement begrenzt. Das Trägerelement und das Fensterelement bilden zusammen den Verkapselungsschlauch aus. Im Folgenden ist der von dem Trägerelement und dem Fensterelement gebildete Hohlraum als "LED-Kanal" bezeichnet.

Eine solche Verkapselung ist beispielsweise in der US 2017/0023192 A1 beschrieben, deren Offenbarungsgehalt insofern hiermit durch Rückbezug aufgenommen wird.

Das LED-Lichtband ist derart auf dem Trägerelement angeordnet, dass zumindest ein Großteil des von den LEDs emittieren Lichts in das Fensterelement gelangt.

Der Verkapselungsschlauch kann mittels Co-Extrusion hergestellt sein. Geeignete Materialien für das Trägerelement sind beispielsweise Silikon-, PVC- oder PUR-Materialien sowie Kombinationen dieser Materialien, welche beispielsweise mit einem Füllstoff gefüllt sind, der eine von den LED-Chips emittierte Strahlung reflektiert. Geeignete Materialien für das Fensterelement sind beispielsweise transparente oder transluzente Silikon-, PVC- oder PUR-Materialien sowie Kombinationen dieser Materialien.

Der vorliegenden Erfindung liegt insbesondere die Aufgabe zugrunde, den Verkapselungsschlauch insbesondere hinsichtlich einer variablen Ausgestaltung von entsprechenden linearen Leuchtdiodenmodulen weiterzubilden.

Diese Aufgabe wird mit den Merkmalen des Patenanspruches 1 gelöst. Ein lineares Leuchtdiodenmodul mit einem solchen Verkapselungsschlauch ist in Anspruch 9 angegeben. Vorteilhafte Ausgestaltungen des Verkapselungsschlauches bzw. des linearen Leuchtdiodenmoduls sind in den Unteransprüchen angegeben. Der Offenbarungsgehalt der Patentansprüche wird hiermit durch Rückbezug in die vorliegende Beschreibung aufgenommen.

Der Verkapselungsschlauch weist im Trägerelement mindestens einen entlang des LED-Kanals verlaufenden weiteren Kanal auf, der dazu vorgesehen ist, elektrisch, thermisch und/oder mechanisch wirksame Elemente in den Verkapselungsschlauch einzuziehen. Dieser Kanal wird im Folgenden kurz als "ETM-Kanal" bezeichnet.

Der ETM-Kanal ist entweder in Längsrichtung des Verkapselungsschlauches allseitig vom Trägerelement umschlossen oder besitzt zum LED-Kanal hin einen entlang der Längsrichtung des Verkapselungsschlauches verlaufenden Spalt, der bei eingezogenem LED-Lichtband vom Flex-PCB zumindest teilweise überdeckt ist.

Bei einer besonderen Ausgestaltung des Verkapselungsschlauches weist auch das Fensterelement mindestens einen entlang des LED-Kanals verlaufenden weiteren Kanal auf, der für die von den LEDs ausgesandte Strahlung eine vorbestimmte optische Wirkung hervorruft und/oder der dazu vorgesehen ist, mindestens ein dahingehend optisch wirksames Element (im Folgenden "Opto-Element"), beispielsweise ein Band oder einen Streifen mit über die gesamte Länge des Lichtbandes linear angeordneten optischen Elementen, in den Verkapselungsschlauch einzuziehen. Damit können Beleuchtungseigenschaften eines entsprechenden linearen Leuchtdiodenmoduls anwendungsspezifisch eingestellt werden. Dieser Kanal wird im Folgenden als "Opto-Kanal" bezeichnet.

Beispielsweise weist der Opto-Kanal selbst oder das Opto-Element lichtstreuende Eigenschaften auf, beispielsweise vermittels Streupartikel. Zusätzlich oder alternativ gibt der Opto-Kanal selbst oder das in diesen eingezogene Opto-Element den Abstrahlwinkel des linearen Leuchtdiodenmoduls vor und/oder ruft eine asymmetrische Abstrahlung des LED-Lichtbandes hervor.

Ebenso kann beispielsweise mittels geeigneter Formgebung des Fensterelements und Verwendung einer asymmetrischen Linearlinse in einem seitlich zum LED-Lichtband verlaufenden Opto-Kanal mittels eines Topview-LED-Lichtbandes ein lineares Sideview-Leuchtdiodenmodul realisiert werden.

Bei einer ersten Ausgestaltung eines linearen Leuchtdiodenmoduls mit einem Verkapselungsschlauch, wie er oben grundlegend oder in seiner besonderen Ausgestaltung beschrieben ist, sind in dem ETM-Kanal ein elektronisches Baugruppenelement zur Steuerung und/oder Regelung des LED-Lichtbandes angeordnet. Diese können ebenso wie das LED-Lichtband auf einem Flex-PCB montiert und verschaltet sein.

Bei einer zweiten Ausgestaltung eines linearen Leuchtdiodenmoduls sind in dem ETM-Kanal elektrische Versorgungsleitungen für das LED-Lichtband angeordnet. Dadurch ist beispielsweise eine beidseitige (an beiden Enden) Stromeinspeisung in das LED-Lichtband möglich. Damit reduziert sich die Verlustleistung im LED-Lichtband und es können längere lineare Leuchtdiodenmodule realisiert werden.

Elektronisches Baugruppenelement und elektrische Versorgungsleitungen werden im Folgenden kollektiv mit "Elektronikelement" bezeichnet.

Bei einer dritten Ausgestaltung eines linearen Leuchtdiodenmoduls sind die erste und die zweite Ausgestaltung miteinander kombiniert.

Bei einer vierten Ausgestaltung eines linearen Leuchtdiodenmoduls ist in dem ETM-Kanal mindestens ein Formgebungselement - beispielsweise ein Stab, eine Schiene oder ein Profil - angeordnet, welches vorgebogen oder biegsam ist. Damit kann die Form bzw. der Verlauf des linearen Leuchtdiodenmoduls vorgegeben bzw. nachträglich angepasst werden.

Bei einer fünften Ausgestaltung eines linearen Leuchtdiodenmoduls sind die erste und die vierte Ausgestaltung miteinander kombiniert.

Bei einer sechsten Ausgestaltung eines linearen Leuchtdiodenmoduls sind die zweite und die vierte Ausgestaltung miteinander kombiniert.

Bei einer siebten Ausgestaltung eines linearen Leuchtdiodenmoduls sind die dritte und die vierte Ausgestaltung miteinander kombiniert.

Bei einer achten Ausgestaltung eines linearen Leuchtdiodenmoduls ist in dem ETM-Kanal mindestens ein thermisch gut leitendes Wärmeableitungselement - beispielsweise ein Kupferstab oder eine Kupferschiene - angeordnet. Damit kann das Thermomanagement im linearen Leuchtdiodenmodul verbessert werden. Alternativ kann gegebenenfalls ein in den ETM-Kanal eingezogenes Elektronik-Element (wie in den ersten drei Ausgestaltungen beschrieben) oder Formgebungselement (wie in der vierten Ausgestaltung beschrieben) verbesserte Wärmeableitungseigenschaften aufweisen, um das Thermomanagement im linearen Leuchtdiodenmodul zu verbessern.

Sämtliche oben beschriebenen acht Ausgestaltungen eines linearen Leuchtdiodenmoduls sind untereinander bedarfsgemäß kombinierbar.

Ebenso können zwei oder alle der oben beschriebenen Funktionalitäten von Elektronikelement, Formgebungselement und Wärmeableitungselement in einem einzigen ergänzenden Element realisiert sein. Elektronikelement, Formgebungselement, Wärmeableitungselement bzw. ein wie oben beschrieben kombiniertes Element werden im Folgenden mit "ETM-Element" bezeichnet.

Mit einem Verkapselungsschlauch gemäß der Erfindung oder einer ihrer Ausgestaltungen können auf technisch einfache Weise komplex aufgebaute lineare Leuchtdiodenmodule bereitgestellt werden, welche zudem den Anforderungen der Schutzklasse IP67 genügen.

Ein flexibles lineares LED-Lichtband zur Verwendung in einem linearen Leuchtdiodenmodul gemäß einer der vorliegend erläuterten Ausführungsformen, Ausgestaltungen und Ausführungsbeispielen ist beispielsweise im Datenblatt BLONE1300024DC12000830000W20 (verfügbar unter https://cdn2.regroshop.at/medias/sys Regro/sheets/sheets/h03/ hd8/9006597767198/Te-BL124120003020.pdf) beschrieben. Hierbei handelt es sich um ein Topview-LED-Lichtband, bei dem die optischen Abstrahlachsen der auf dem Flex-PCB montierten LED-Bauelemente nominal senkrecht zur Montagefläche des Flex-PCBs verlaufen. Alternativ zu einem flexiblen linearen LED-Lichtband kann, falls kein flexibles lineares Leuchtdiodenmodul vorgesehen ist, auch ein starres lineares LED-Lichtband verwendet sein.

Der Verkapselungsschlauch und das lineare Leuchtdiodenmodul werden im Folgenden anhand von Ausführungsbeispielen in Verbindung mit den Figuren 1 bis 5 näher erläutert. Es zeigen:
Figur 1, eine schematische Darstellung eines Schnittes durch ein erstes Ausführungsbeispiel des Verkapselungsschlauches;
Figur 2, eine schematische Darstellung eines Schnittes durch ein zweites Ausführungsbeispiel des Verkapselungsschlauches;
Figur 3, eine schematische Darstellung eines Schnittes durch ein drittes Ausführungsbeispiel des Verkapselungsschlauches;
Figur 4, eine schematische Darstellung eines Schnittes durch ein viertes Ausführungsbeispiel des Verkapselungsschlauches; und
Figur 5, eine schematische Darstellung einer perspektivischen Ansicht eines Verkapselungsschlauches gemäß einem der drei Ausführungsbeispiele.

In den unterschiedlichen Ausführungsbeispielen, Ausführungsformen und Ausgestaltungen sind gleiche und gleichwirkende Bestandteile figurenübergreifend jeweils mit denselben Bezugszeichen versehen. Die Figuren sind grundsätzlich nicht maßstabsgetreu. Die Größenverhältnisse der verschiedenen Bestandteile untereinander entsprechen nicht der Wirklichkeit. Beispielsweise können vergleichsweise kleine Elemente zur besseren Veranschaulichung übertrieben groß dargestellt sein und umgekehrt.

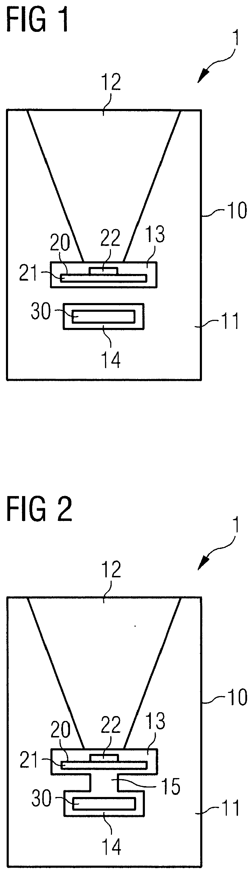

Das in Figur 1 dargestellte Ausführungsbeispiel umfasst einen langgestreckten Verkapselungsschlauch 10, der von einem langgestreckten Trägerelement 11 und einem langgestreckten Fensterelement 12 gebildet ist. In diesem Verkapselungsschlauch 10 ist ein LED-Kanal 13 vorgesehen, der in Längsrichtung des Verkapselungsschlauches 10 (im Folgenden nur allgemein mit "Längsrichtung" bezeichnet) durch den gesamten Verkapselungsschlauch 10 verläuft und der einerseits vom Trägerelement 11 und andererseits vom Fensterelement 12 begrenzt ist.

Der Verkapselungsschlauch 10 ist beispielsweise mittels Co-Extrusion hergestellt. Das Trägerelement 11 ist beispielsweise gefertigt aus einem Silikon-, PVC- oder PUR-Material oder aus einer Kombination dieser Materialien, welches beispielsweise mit einem Füllstoff (beispielsweise ein Weißpigment) gefüllt ist, der eine von den LED-Chips emittierte Strahlung reflektiert. Das Fensterelement 12 ist beispielsweise aus einem transparenten oder transluzenten Silikon-, PVC- oder PUR-Material oder einer Kombination dieser Materialien gefertigt. Das Fensterelement 12 kann alternativ beispielsweise aus zwei oder mehr Schichten aufgebaut sein, von denen eine (beispielsweise eine äußere Schicht) transparent und eine (beispielsweise eine innere Schicht) transluzent ist, um eine Homogenisierung des von den LEDs ausgesandten Lichts zu erzielen.

Nach Herstellung des Verkapselungsschlauches 10 kann in den LED-Kanal 13 ein LED-Lichtband 20 eingezogen und montiert werden. Dieses umfasst beispielsweise ein Flex-PCB 21 mit einer Mehrzahl von linear hintereinander montierten und elektrisch verschalteten LEDs 22, so wie es beispielsweise im Datenblatt BLONE1300024DC12000830000W20 (verfügbar unter https://cdn2.regroshop.at/medias/sys_Regro/sheets/sheets/h03/ hd8/9006597767198/Te-BL124120003020.pdf) beschrieben ist.

Im Trägerelement 11 verläuft entlang des LED-Kanals 13 ein ETM-Kanal 14, der in Längsrichtung vollständig vom Trägerelement 11 umschlossen ist. Der ETM-Kanal 14 ist dazu vorgesehen, dass nachträglich in den Verkapselungsschlauch 10 ein wie oben beschriebenes ETM-Element 30 eingezogen wird.

Nach Montage des LED-Lichtbandes 20 und des ETM-Elements 30 werden zur Fertigstellung eines linearen Leuchtdiodenmoduls die Enden des Verkapselungsschlauches 10 beispielsweise mittels geeigneter Kappen oder anderweitiger Verschlussmittel, welche elektrische Durchführungen zum elektrischen Anschließen des Moduls aufweisen, verschlossen.

Das in Figur 2 dargestellte zweite Ausführungsbeispiel unterscheidet sich von dem ersten Ausführungsbeispiel von Figur 1 dadurch, dass der ETM-Kanal 14 zum LED-Kanal 13 hin einen entlang der Längsrichtung verlaufenden Spalt 15 aufweist, der bei eingezogenem LED-Lichtband 20 von dessen Flex-PCB 21 zumindest teilweise überdeckt ist. Dies ermöglicht, falls erforderlich, eine direkte elektrische, thermische oder mechanische Verbindung zwischen dem LED-Lichtband 21 und einer im ETM-Kanal 14 angeordneten ETM-Elements 30 des linearen Leuchtdiodenmoduls.

Für die beiden oben beschriebenen Ausführungsbeispiele gilt beispielsweise Folgendes:
In den ETM-Kanal 14 können elektronische Baugruppen zur Steuerung und/oder Regelung des LED-Lichtbandes 20 eingezogen werden. Diese können ebenso wie das LED-Lichtband 20 auf einem Flex-PCB montiert und verschaltet sein.

Alternativ oder zusätzlich können in den ETM-Kanal 14 elektrische Versorgungsleitungen für das LED-Lichtband 20 eingezogen werden. Dadurch ist beispielsweise eine beidseitige (an beiden Enden) Stromeinspeisung in das LED-Lichtband 20 möglich. Damit reduziert sich die Verlustleistung im LED-Lichtband 20 und es können längere lineare Leuchtdiodenmodule realisiert werden.

Alternativ oder zusätzlich zu einer der beiden oder zusätzlich zu beiden obigen Alternativen kann in den ETM-Kanal 14 mindestens ein Formgebungselement - beispielsweise ein Stab, eine Schiene oder ein Profil beispielsweise aus einem metallischen Werkstoff, einem Kunststoff oder aus einem Verbundstoff - eingezogen werden, welches vorgebogen oder biegsam ist. Damit ist die Form bzw. kann der Verlauf des linearen Leuchtdiodenmoduls vorgegeben bzw. nachträglich angepasst werden.

Alternativ oder zusätzlich zu einer der drei oder zusätzlich zu allen drei obigen Alternativen kann in den ETM-Kanal 14 mindestens ein Wärmeableitungselement - beispielsweise ein Kupferstab oder eine Kupferschiene - eingezogen werden. Damit kann das Thermomanagement im linearen Leuchtdiodenmodul verbessert werden.

Alternativ weist gegebenenfalls ein in den ETM-Kanal 30 eingezogenes Elektronik-Element (wie oben in den ersten drei Ausgestaltungen beschrieben) oder Formgebungselement (wie oben in der vierten Ausgestaltung beschrieben) verbesserte Wärmeableitungseigenschaften auf, um das Thermomanagement im linearen Leuchtdiodenmodul zu verbessern.

Bei einer weiteren Alternative sind andere zwei oder alle der oben beschriebenen Funktionalitäten von Elektronikelement, Formgebungselement und Wärmeableitungselement in einem einzigen ergänzenden ETM-Element 30 realisiert.

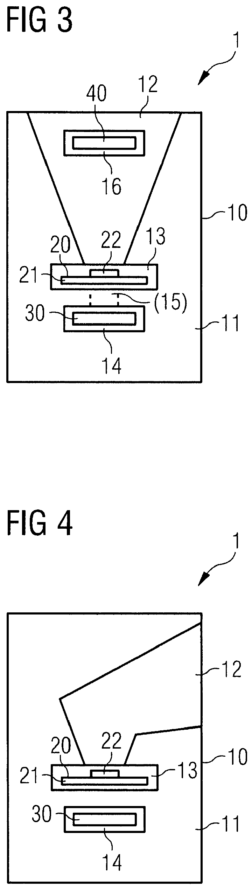

Das Ausführungsbeispiel gemäß Figur 3 unterscheidet sich von dem der Figur 1 oder von dem der Figur 2 dadurch, dass das Fensterelement 12 mindestens einen entlang des LED-Kanals 13 verlaufenden Opto-Kanal 16 aufweist. Der gestrichelt eingezeichnete Spalt 15 und die Klammern um das zugehörige Bezugszeichen bringen zum Ausdruck, dass das Trägerelement 11 gemäß erstem Ausführungsbeispiel oder gemäß zweitem Ausführungsbeispiel ausgestaltet sein kann.

Der Opto-Kanal 16 weist für die von den LEDs ausgesandte Strahlung eine vorbestimmte optische Wirkung auf und/oder ist dazu vorgesehen, mindestens ein dahingehend optisch wirksames Opto-Element 40, beispielsweise ein Band oder einen Streifen mit linear über die gesamte Länge des LED-Lichtbandes 20 angeordneten optischen Elementen, in den Verkapselungsschlauch 10 einzuziehen. Damit können Beleuchtungseigenschaften des linearen Leuchtdiodenmoduls eingestellt werden.

Beispielsweise kann der Opto-Kanal 16 selbst oder das in diesen eingezogene optische Element lichtstreuende Eigenschaften aufweisen, beispielsweise vermittels Streupartikel. Zusätzlich oder alternativ kann der Opto-Kanal 16 selbst oder das optische Element den Abstrahlwinkel des linearen Leuchtdiodenmoduls vorgeben und/oder eine asymmetrische Abstrahlung des linearen Leuchtdiodenmoduls hervorrufen.

Ebenso kann beispielsweise mittels geeigneter Formgebung des Fensterelements 12 und Verwendung einer asymmetrischen Linearlinse als Opto-Element 40 in einem seitlich zum LED-Lichtband verlaufenden Opto-Kanal 16 mittels eines Topview-LED-Lichtbandes ein lineares Sideview-Leuchtdiodenmodul realisiert werden.

Das Ausführungsbeispiel gemäß Figur 4 unterscheidet sich von den vorangehend beschriebenen Ausführungsbeispielen dadurch, dass das Fensterelement 12 im Querschnitt senkrecht zur Längsrichtung derart gewinkelt ausgestaltet ist, dass das von den LEDs 22 emittierte Licht zu einer Seitenfläche des Verkapselungsschlauches 10 umgelenkt und dort ausgekoppelt wird. Sämtliche Elemente der oben beschriebenen Ausführungsbeispiele können auch in diesem Ausführungsbeispiel vorhanden sein. Beispielsweise kann in einem Opto-Kanal 16 des gewinkelten Fensterelements 12 als Opto-Element 40 ein optisches Prisma angeordnet sein.

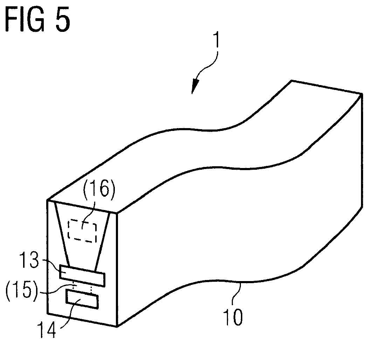

Der in Figur 5 perspektivisch dargestellte Verkapselungsschlauch kann gemäß einem der oben beschriebenen Ausführungsbeispiele ausgestaltet sein. Dies wird durch den gestrichelt eingezeichneten Spalt 15 und den gestrichelt eingezeichneten Opto-Kanal 16 und die Klammern um die zugehörigen Bezugszeichen angezeigt.

Die Erläuterung der Erfindung anhand der Ausführungsbeispiele ist nicht als Einschränkung der Erfindung auf diese zu verstehen. Vielmehr können die oben allgemein beschriebenen Elemente und die in den Ausführungsbeispielen beschriebenen Elemente je nach Anforderungsprofil für ein lineares Leuchtdiodenmodul unterschiedlich miteinander kombiniert werden und jedes einzelne Element beinhaltet für sich alleine den der Erfindung zugrundeliegenden eingangs geschilderten Gedanken.

In den Rahmen der Erfindung fällt auch eine Ausgestaltung des Verkapselungsschlauches mit einem LED-Kanal, der nur mindestens einen wie oben beschriebenen Opto-Kanal im Fensterelement aber keinen ETM-Kanal im Trägerelement aufweist. Analog dazu fällt auch ein ohne ETM-Kanal ausgestaltetes lineares Leuchtdiodenmodul mit einem solchen Verkapselungsschlauch und einem wie oben beschrieben ausgestalteten Opto-Kanal und/oder Opto-Element in den Rahmen der Erfindung. Ein Ausführungsbeispiel für einen solchen Verkapselungsschlauch bzw. für ein entsprechendes lineares Leuchtdiodenmodul würde dann dem Ausführungsbeispiel gemäß Figur 3 entsprechen, in Abweichung davon aber keinen ETM-Kanal aufweisen.

### Bezugszeichenliste

- 1: Lineares Leuchtdiodenmodul
- 10: Verkapselungsschlauch
- 11: Trägerelement
- 12: Fensterelement
- 13: LED-Kanal
- 14: ETM-Kanal
- 15: Spalt
- 16: Opto-Kanal
- 20: LED-Lichtband
- 21: Flex-PCB
- 22: LED
- 30: ETM-Element
- 40: Opto-Element

## Patentansprüche

1. Verkapselungsschlauch (10) für ein mindestens ein LED-Lichtband (20) aufweisendes lineares Leuchtdiodenmodul (1), mit einem entlang dessen Längsrichtung allseitig geschlossenen vorgefertigten Profil, welches mit einem in Längsrichtung vollständig durch den Verkapselungsschlauch verlaufenden LED-Kanal (13) versehen ist, der dazu vorgesehen ist, in diesen das LED-Lichtband (20) einzuziehen, wobei der LED-Kanal (13) einerseits von einem lichtreflektierenden Trägerelement (11) und andererseits von einem lichtdurchlässigen Fensterelement (12) begrenzt ist,
**dadurch gekennzeichnet, dass**
das Trägerelement (11) mindestens einen entlang des LED-Kanals (13) verlaufenden ETM-Kanal (14) aufweist, der dazu vorgesehen ist, in diesen mindestens ein elektrisch, thermisch und/oder mechanisch wirksames Element (30) in den Verkapselungsschlauch einzuziehen.

2. Verkapselungsschlauch gemäß Anspruch 1,
**dadurch gekennzeichnet, dass**
der ETM-Kanal (14) in dessen Längsrichtung allseitig vom Trägerelement (11) umschlossen ist.

3. Verkapselungsschlauch gemäß Anspruch 1,
**dadurch gekennzeichnet, dass**
der ETM-Kanal (14) zum LED-Kanal (13) hin einen entlang dessen Längsrichtung verlaufenden Spalt (15) aufweist.

4. Verkapselungsschlauch gemäß Anspruch 3,
**dadurch gekennzeichnet, dass**
der Spalt (15) über die gesamte Länge des Verkapselungsschlauches durchgängig ist.

5. Verkapselungsschlauch nach einem der Ansprüche 1 bis 4,
**dadurch gekennzeichnet, dass**
das Fensterelement (12) mindestens einen entlang des LED-Kanals (13) verlaufenden Opto-Kanal (16) aufweist, der dazu ausgebildet ist, für die vom LED-Lichtband (20) ausgesandte Strahlung eine vorbestimmte optische Wirkung hervorzurufen, und/oder der dazu vorgesehen ist, in diesen mindestens ein Opto-Element (40) einzuziehen.

6. Verkapselungsschlauch nach Anspruch 5,
**dadurch gekennzeichnet, dass**
der Opto-Kanal (16) lichtstreuende Eigenschaften aufweist.

7. Verkapselungsschlauch nach Anspruch 5 oder 6,
**dadurch gekennzeichnet, dass**
der Opto-Kanal (16) derart lichtreflektierende und/oder lichtbrechende Flächen aufweist, die den Abstrahlwinkel des linearen Leuchtdiodenmoduls vorgeben und/oder eine asymmetrische Abstrahlung des LED-Lichtbandes hervorrufen.

8. Verkapselungsschlauch nach einem der vorangehenden Ansprüche,
**dadurch gekennzeichnet, dass**
das Fensterelement und das Trägerelement derart geformt und reflektierend ausgebildet sind, dass mittels eines Topview-LED-Lichtbandes ein lineares Sideview-Leuchtdiodenmodul realisierbar ist.

9. Lineares Leuchtdiodenmodul (1) mit einem Verkapselungsschlauch (10) gemäß einem der Ansprüche 1 bis 8,
bei dem im ETM-Kanal (14) ein elektronisches Baugruppenelement zur Steuerung und/oder Regelung eines im LED-Kanal (13) angeordneten LED-Lichtbandes (20) angeordnet ist.

10. Lineares Leuchtdiodenmodul nach Anspruch 9, bei dem elektronische Bauelemente des Baugruppenelements auf einem Flex-PCB montiert und verschaltet sind.

11. Lineares Leuchtdiodenmodul nach Anspruch 9 oder 10, bei dem im ETM-Kanal (14) elektrische Versorgungsleitungen für das LED-Lichtband (20) angeordnet.

12. Lineares Leuchtdiodenmodul nach einem der Ansprüche 9 bis 11, bei dem im ETM-Kanal (14) mindestens ein Formgebungselement angeordnet ist, welches vorgebogen oder biegsam ist.

13. Lineares Leuchtdiodenmodul nach einem der Ansprüche 9 bis 12, bei dem im ETM-Kanal (14) mindestens ein Wärmeableitungselement angeordnet ist.

14. Lineares Leuchtdiodenmodul nach einem der Ansprüche 9 bis 13, bei dem im ETM-Kanal (14) mindestens ein elektronisches Baugruppenelement angeordnet ist, in welches ein Wärmeableitungselement integriert ist.

15. Lineares Leuchtdiodenmodul nach einem der Ansprüche 9 bis 13, bei dem im ETM-Kanal (14) mindestens ein elektronisches Baugruppenelement angeordnet ist, in welches ein Formgebungselement integriert ist.
